# EUROPEAN PATENT SPECIFICATION

(11) **EP 1 993 173 B1**
(45) Date of publication and mention of the grant of the patent: **16.11.2016**
(21) Application number: 08008775.2
(22) Date of filing: 09.05.2008
(51) Int. Cl.: H01R 12/72, H01R 12/70, H01R 12/71, H05K 3/30

(54) **A set of circuit board connectors and a method of mounting a connector to a circuit board**
Leiterplattensteckersatz und Verfahren zum Montieren eines Steckers auf einer Leiterplatte
Ensemble de connecteurs de carte de circuit et procédé d'assemblage d'un connecteur sur une carte de circuit

(30) Priority: 16.05.2007 JP 2007130017
(43) Date of publication of application: 19.11.2008
(73) Proprietor: Sumitomo Wiring Systems, Ltd., Yokkaichi-city, Mie 510-8503 (JP)
(72) Inventor: Shibata, Takahiro, Yokkaichi-city MIE 510-8503 (JP); Matsushita, Yasuo, Yokkaichi-city MIE 510-8503 (JP); Tanaka, Tsutomu, Yokkaichi-city MIE 510-8503 (JP)
(74) Representative: Müller-Boré & Partner Patentanwälte PartG mbB

(56) References cited:
- DE-U1-202006 004 587
- US-A- 6 030 241
- US-A1- 2003 190 839
- "PRINTED CIRCUIT BOARD AND COMPONENT KEYING AND RETENTION DESIGN", IBM TECHNICAL DISCLOSURE BULLETIN, INTERNATIONAL BUSINESS MACHINES CORP. (THORNWOOD), US, vol. 33, no. 4, 1 September 1990 (1990-09-01), pages 216-218, XP000106401, ISSN: 0018-8689

## Description

The present invention relates to a set of circuit board connectors mountable on a circuit board and to a method of mounting a connector to a circuit board.

US 2003/0190839 A1 discloses a connector for a circuit board and a method of forming it. A housing of the connector has vertical screw holes parallel to a connecting direction of the housing and horizontal screw holes normal to the connecting direction. Thus, the housing is both horizontally and vertically mountable on a circuit board, and flexibility in the use of the housing is improved. Further, the horizontal screw holes are normal to the connecting direction and can be formed by a pair of molds movable along the connecting direction.

US-A-6030241 discloses a printed circuit board connector formed by a fixed base portion that is provided in a fixed manner onto a printed circuit board and a movable base portion that can be mated as one with the fixed base portion in either of two (or three) different directions with respect to the fixed base portion, these directions differing from each other by 90 degrees. A cable-side connector can be connected to the movable fixed base portion.

DE 20 2006 004587 U1 discloses a straight connection adapter and a right-angled connection adapter to provide multiple electrical connections between electronic circuit boards.

Japanese Unexamined Patent Publication No. 2006-4642 discloses a vertical connector provided with a receptacle, into which a mating connector is fittable, a plurality of terminal fittings mounted through the back wall of the receptacle, and mounting portions projecting outwardly from the receptacle and fixed to the circuit board by screws, wherein the terminal fittings are formed straight as a whole and the connector is mounted on a circuit board with an open surface of the receptacle facing vertically.

On the other hand, Japanese Unexamined Patent Publication No. 2006-73237 discloses a horizontal connector likewise provided with a receptacle, into which a mating connector is fittable, a plurality of terminal fittings mounted through the back wall of the receptacle, and mounting portions projecting outward from the receptacle and fixed to the circuit board by screws, wherein the terminal fittings are bent in L-shape and the connector is mounted on a circuit board with an open surface of the receptacle facing horizontally.

For both the vertical connector and the horizontal connector, the circuit board is formed with connection holes, into which one ends of the terminal fittings are inserted, and fixing holes at positions corresponding to the mounting portions.

An object of the present invention is fixing a receptacle of a connector with desired orientation to a circuit board.

This object is solved according to the invention by the features of the independent claims. Preferred embodiments of the invention are subject of the dependent claims.

Accordingly, since the arrangements of the connection holes and the fixing holes of the circuit board are common to the first connector and second connector, one type of the circuit board can be used for two types of the connectors, wherefore it is not necessary to prepare special circuit boards for the respective connectors.

In case a solder connecting operation is performed for the terminal fittings at least partly inserted in the connection holes at one end in the column direction with the mounting portions mounted with respect to the fixing holes, an excessive stress can be prevented from acting on the terminal fittings at least partly inserted in the connection holes located at the other end in the column direction due to the solder connecting operation. Thus, the solder connecting operation can be satisfactorily performed at both ends in the column direction.

Since the exposed parts of the respective terminal fittings are covered at the opposite sides in the row direction by the mounting portions, the deformations of the exposed parts due to interference with external matters can be prevented.

Further preferably, the parts of the mounting portions to be mounted with respect to the fixing holes are arranged at least in a pair at the substantially opposite sides of the terminal group in the row direction.

A formation range of the connection holes and the fixing holes of the circuit board can be made smaller in the column direction, wherefore a space in the column direction can be effectively utilized.

According to a further preferred embodiment, the mounting portion has a projecting distance which is set beyond the height of the terminal fitting(s) to be located most closely to the circuit board.

Preferably, the second connector comprises at least one pair of lateral projecting pieces projecting toward the connector board so that one or more exposed parts of the terminal fittings except the leading end portions are arranged to be at least partly protected by the projecting pieces, preferably between the two projecting pieces.

Further preferably, one or more mounting members are at least partly insertable into the fixing holes preferably from a side opposite to the mounting side of the circuit board and the leading ends thereof are engaged with mounting holes of the respective mounting portions.

Most preferably, the mounting members comprise one or more tapping screws, wherein the external threads of the tapping screws can bite in or engage the inner surfaces of the respective mounting holes, whereby the receptacle can be fixed by the tapping screws.

These and other objects, features and advantages of the present invention will become more apparent upon reading of the following detailed description of preferred embodiments and accompanying drawings. It should be understood that even though embodiments are separately described, single features thereof may be combined to additional embodiments.
FIG. 1 is a section of a horizontal connector mounted on a circuit board in a one embodiment of the invention,
FIG. 2 is a rear view of the horizontal connector,
FIG. 3 is a bottom view of the horizontal connector,
FIG. 4 is a front view of the horizontal connector,
FIG. 5 is a side view of the horizontal connector,
FIG. 6 is a section of a vertical connector mounted on the circuit board,
FIG. 7 is a bottom view of the vertical connector,
FIG. 8 is a plan view of the vertical connector, and
FIG. 9 is a plan view showing an essential portion of the circuit board.

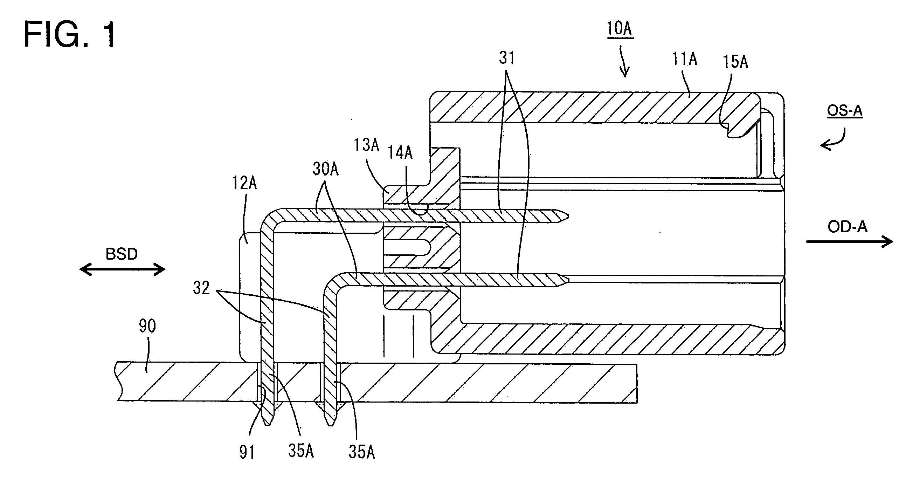

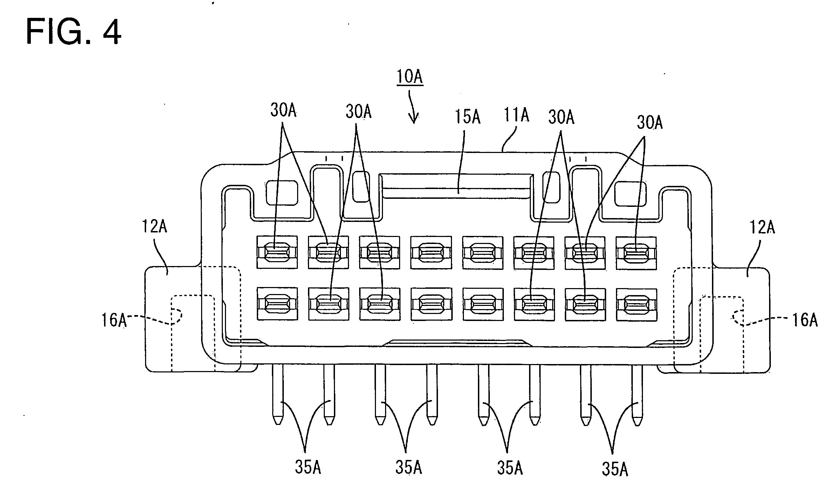

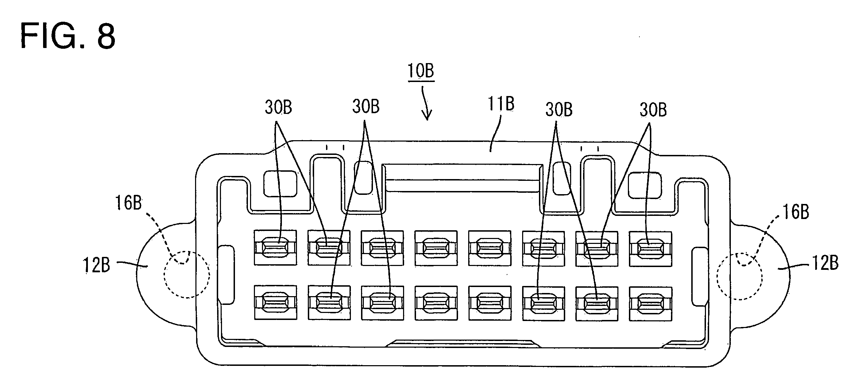

One preferred embodiment of the present invention is described with reference to FIGS. 1 to 9. In this embodiment, two types of connectors (vertical connector 10A, vertical connector 10B) mounted or mountable in or at different postures or positions on a circuit board 90 (such as a printed circuit board) are prepared, and either one of the two connectors 10A, 10B is selectively used depending on the situation.

First of all, the horizontal connector 10A (as a preferred first connector) is described with reference to FIGS. 1 to 5. The horizontal connector 10A is provided with a receptacle 11 A and mounting portions 12A made e.g. of synthetic resin, and terminal fittings 30A made of a conductive (preferably metal) plate. The receptacle 11 A preferably substantially has a laterally long flat shape, a back wall 13A thereof is formed with fitting holes 14A, through which the respective terminal fittings 30A are pressed or inserted to be mounted and at least one lock projection 15A for holding the horizontal connector 10A connected with a mating connector (unillustrated female connector) is provided on the inner surface of the lateral (preferably upper) wall thereof. A plurality of fitting holes 14A are substantially aligned in a width direction at one or more stages, preferably at two (upper and lower) stages, and the terminal fitting(s) 30A is/are individually insertable into the respective fitting hole(s) 14A. With the horizontal connector 10A mounted on a circuit board 90, an opening surface OS-A of the receptacle 11 A is facing in a direction OD-A substantially parallel to the board surface direction BSD of the circuit board 90 (or the direction OD-A substantially lies within a plane of the circuit board 90 on which the horizontal connector 10A is arranged or the direction OD-A is substantially perpendicular to the normal direction of the plane of the circuit board 90), and the mating connector is substantially horizontally at least partly fittable (or fittable along a direction parallel to the board surface direction BSD or to the plane of the circuit board 90) into the receptacle 11A through this open surface from front.

The (preferably each) terminal fitting 30A preferably substantially is a narrow and long tab-shaped terminal bent at an angle different from 0° or 180°, preferably substantially at right angles at an intermediate position and preferably substantially L-shaped as a whole. One end portion of each terminal fitting 30A is a horizontal section 31A arranged substantially in parallel with the board surface direction BSD of the circuit board 90 and penetrating through the back wall 13A of the receptacle 11 A to at least partly project into the receptacle 11 A, and the other end portion thereof is a vertical or angled section 32 arranged at an angle different from 0° or 180°, preferably substantially at right angles to the board surface direction BSD of the circuit board 90 and to be at least partly inserted into a connection hole 91 formed in the circuit board 90 for connection (particularly by press-fitting, soldering or the like). In the terminal fitting 30A, a distal or bottom end portion of the vertical section 32 to be at least partly inserted into the connection hole 91 of the circuit board 90 is a board connecting portion 35A preferably substantially in the form of a round pin, and the remaining part other than the board connecting portion 35A preferably substantially is in the form of a strip wider than the board connecting portion 35A.

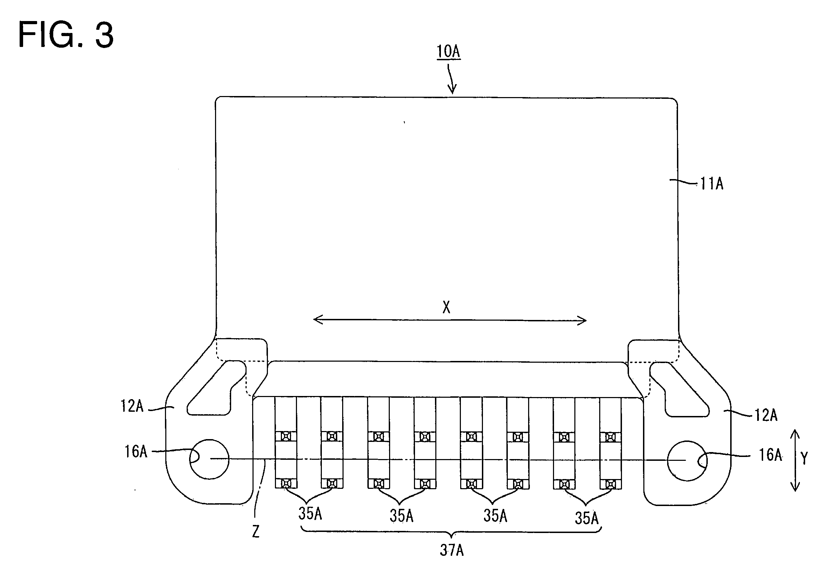

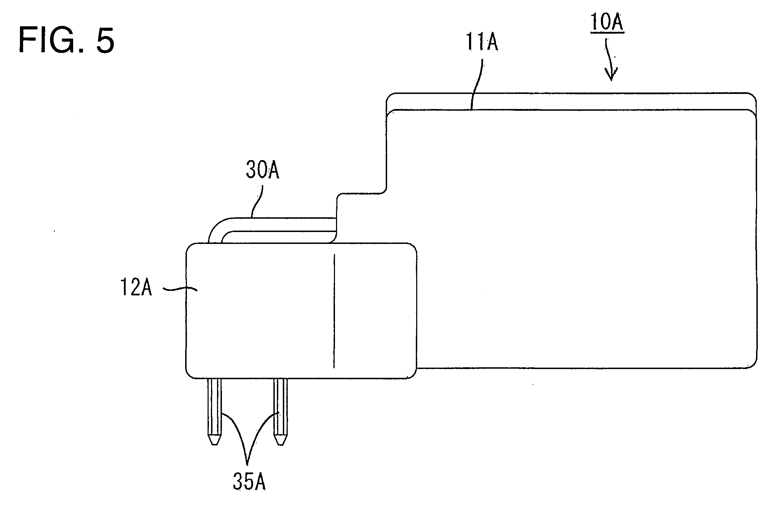

A pair of lateral (left and/or right) mounting portions 12A integrally or unitarily project from the (preferably substantially opposite) side(s) of (preferably the rear end of) the receptacle 11 A. More specifically, the respective mounting portions 12A extend like wings obliquely backward toward the substantially opposite lateral sides from (preferably the rear ends of) the substantially opposite side surfaces of the receptacle 11A in order to avoid interference with exposed parts of the terminal fittings 30A, i.e. are at least partly arranged at the substantially opposite sides of the exposed parts of the terminal fittings 30A as shown in FIG. 3. Each mounting portion 12A preferably substantially is in the form of a block having a flat upper surface (surface substantially opposite to the circuit board 90 whose height is set beyond the height of the single stage (or the closest stage out of a plurality of stages) of fitting holes 14A (preferably between the fitting holes 14A at the upper and lower stages). Accordingly, when this horizontal connector 10A is seen sideways, the exposed parts of the terminal fittings 30A mounted in the fitting holes 14A at the closest stage (lower stage) cannot be seen by being concealed by the respective mounting portions 12A (see FIG. 5).

Each mounting portion 12A is formed with a bottomed mount hole 16A substantially vertically extending (or extending at an angle different from 0° or 180°, preferably substantially normal to the board surface direction BSD) and making a (preferably substantially round) opening only in the bottom surface, and this mounting hole 16A is to be substantially aligned to communicate with a fixing hole 92 formed in the circuit board 90 in the mounted state on the circuit board 90. The mounting holes 16A of the respective mounting portions 12A preferably are arranged in at least one pair at the opposite ends in a row direction (horizontal direction X shown in FIG. 3) with a terminal group 37A as an array of a plurality of board connecting portions 35A in the row direction X and a column direction (vertical direction Y in FIG. 3) located therebetween. More specifically, the mounting holes 16A preferably are arranged at the opposite sides of the terminal group 37A in the row direction X and on a center line Z passing the center of the terminal group 37A in the column direction Y.

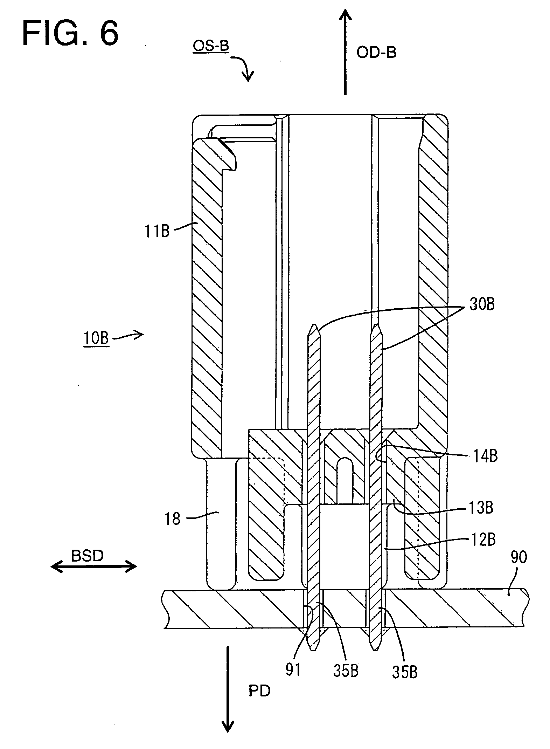

Next, the vertical connector 10B (as a preferred second connector) shown in FIGS. 6 to 8 is described. Similar to the horizontal connector 10A, the vertical connector 10B is provided with a receptacle 11 B and mounting portions 12B made e.g. of synthetic resin, and terminal fittings 30B made of a conductive (preferably metal) plate. The receptacle 11 B preferably substantially has a laterally long flat shape, and a back wall 13B thereof is formed with fitting holes 14B, through which the terminal fittings 30B at least partly are pressed or inserted to be mounted. These fitting holes 14B are arranged at the substantially same positions as the fitting holes 14A of the horizontal connector 10A. With the vertical connector 10B mounted on the circuit board 90, an opening surface OS-B of the receptacle 11 B is facing in a direction OD-B at an angle different from 0° or 180°, preferably substantially normal to the board surface direction BSD of the circuit board 90, and a mating connector is at least partly fittable in a direction at an angle different from 0° or 180° to the board surface direction BSD, preferably substantially vertically fittable (or at least partly fittable or insertable substantially perpendicularly to the board surface direction BSD) into the receptacle 11 B through this open surface from above.

The (preferably each) terminal fitting 30B preferably substantially is narrow, long and straight in the vertical direction as a whole, and an upper part thereof at least partly projects into the receptacle 11 B, an intermediate part thereof penetrates in a direction substantially normal to the board surface direction BSD (substantially vertically) through the back wall 13B of the receptacle 11 B, and a lower part thereof projects downward from the back wall 13B of the receptacle 11 B to be exposed. In the terminal fitting 30B, a part to be at least partly inserted into the connection hole 91 of the circuit board 90 is a board connecting portion 35B (preferably substantially in the form of a round pin), and the remaining part other than the board connecting portion 35A is in the form of a strip wider than the board connecting portion 35B. Accordingly, the terminal fitting 30B preferably substantially is linear as a whole.

At least one pair of lateral (left and/or right) projecting pieces 18 project downward adjacent to (preferably from the substantially opposite sides of) the bottom end of the receptacle 11B, and exposed parts of the terminal fittings 30B except the leading end portions are arranged to be at least partly protected by the one or more projecting pieces 18, preferably between the two projecting pieces 18. A pair of lateral (left and/or right) mounting portions 12B are formed at the (preferably substantially opposite) side(s) of the bottom end of the receptacle 11B while being integrally or unitarily joined with the (preferably both) respective projecting piece(s) 18. Each mounting portion 12B preferably has a bottomed (preferably substantially cylindrical) shape extending substantially in the projecting direction PD of the corresponding projecting piece 18 and preferably is internally formed with a mounting hole 16B substantially vertically extending and making a (preferably substantially round) opening only in the bottom surface to be able to communicate with the fixing hole 92 of the circuit board 90.

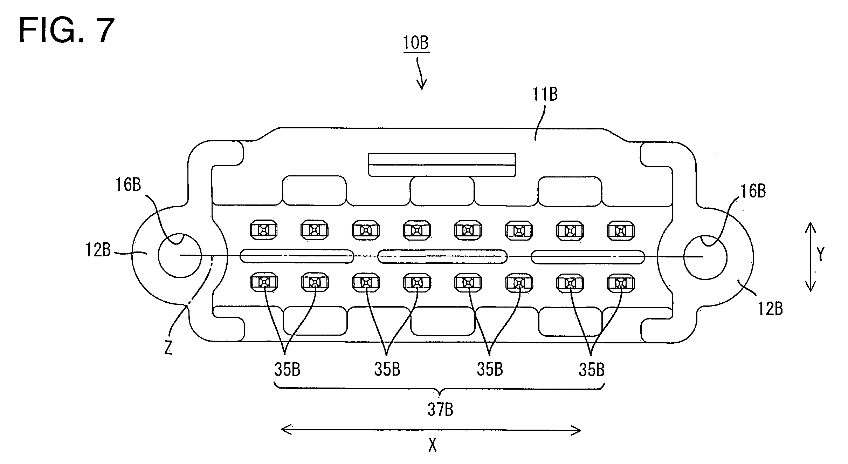

The mounting holes 16B of the respective mounting portions 12B preferably are arranged in a pair at the opposite ends in a row direction (horizontal direction X shown in FIG. 7) with a terminal group 37B as an array of a plurality of board connecting portions 35B in the row direction X and a column direction (vertical direction Y in FIG. 7) located therebetween. More specifically, the mounting holes 16B are arranged at the substantially opposite sides of the terminal group 37B in the row direction X and on a center line Z passing the center of the terminal group 37A in the column direction Y.

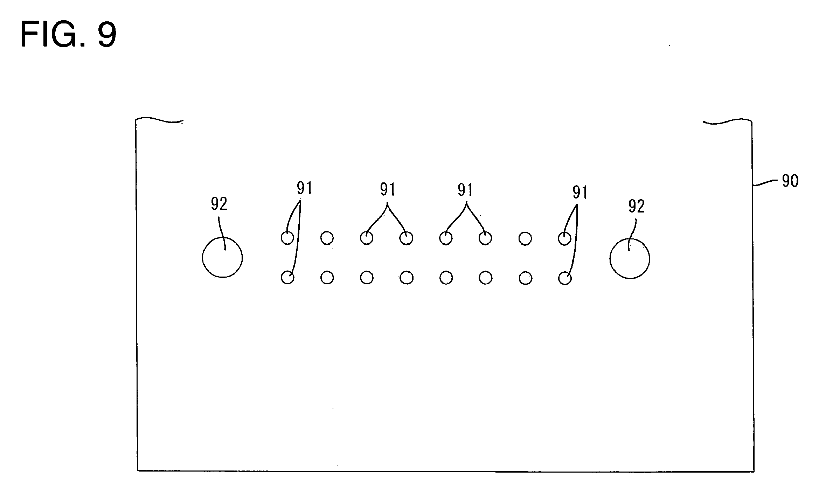

In the horizontal connector 10A and vertical connector 10B, the board connecting portions 35A, 35B of the respective terminal fittings 30A, 30B and the mounting holes 16A, 16B of the respective mounting portions 12A, 12B preferably are identical in shape and/or arranged at the same intervals, so that the shapes and arrangements thereof coincide. Thus, if the board connecting portions 35A, 35B of the terminal fittings 30A, 30B of the horizontal connector 10A and vertical connector 10B and the mounting holes 16A, 16B of the mounting portions 12A, 12B thereof are projected on the board surface of the circuit board 90, projected images substantially match and overlap at the same positions. On the other hand, the shapes and arrangements of the connection holes 91 and fixing holes 92 of the circuit board 90 substantially conform to those of the board connecting portions 35A, 35B of the terminal fittings 30A, 30B and the mounting holes 16A, 16B of the mounting portions 12A, 12B and, hence, conform to both horizontal connector 10A and vertical connector 10B (see FIG. 9).

Next, functions of this embodiment are described.

Upon mounting the circuit board connector on the circuit board 90, either one of the horizontal connector 10A or vertical connector 10B is selected in consideration of whether or not interference with peripheral parts can be avoided, connection sides and/or directions with the respective mating connector(s), dimensional considerations and/or other factors.

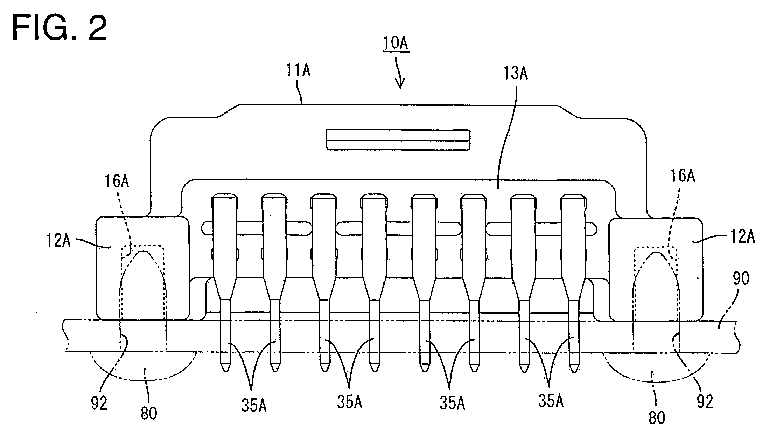

In the case of selecting the horizontal connector 10A, the bent or L-shaped terminal fittings 30A are first mounted by being at least partly pressed or inserted into the fitting holes 14A from an insertion side, preferably substantially from behind. Subsequently, upon mounting the horizontal connector 10A on or to the circuit board 90, the board connecting portions 35A of the respective terminal fittings 30A are at least partly inserted or fitted into the connection holes 91 of the circuit board 90 from a mounting side (preferably substantially from above) and the mounting holes 16A of the respective mounting portions 12A are substantially aligned to communicate with the fixing holes 92 of the circuit board 90. Subsequently, as shown in FIG. 2, mounting members (such as tapping screws 80) are inserted into the fixing holes 92 preferably from a side opposite to the mounting side (preferably substantially from the underside) of the circuit board 90 and the leading ends thereof are engaged with (preferably pressed into) the mounting holes 16A of the respective mounting portions 12A. Then, preferably the external threads of the tapping screws 80 bite in or engage the inner surfaces of the respective mounting holes 16A, whereby the receptacle 11 A is fixed by the screws 80.

Preferably thereafter, the board connecting portions 35A of the respective terminal fittings 30A are electrically connected with conduction paths (not shown) printed on the circuit board 90 preferably by soldering. It should be understood, however, that the terminal fittings 30A may be alternatively or additionally connected to the conduction paths by means of press-fitting. In this case, if the respective mounting holes 16A are formed at positions displaced toward one end of the terminal groups 37A of the board connecting portions 35A in the column direction Y and the receptacle 11 A is fixed at the one side in the column direction Y, the circuit board 90 may be inclined in such a direction that the board connecting portions 35A located at the other end in the column direction Y come out of the corresponding connection holes 91 to cause the action of an excessive stress on the other end of the terminal group 37A in the column direction Y while the board connecting portions 35A located at the one end in the column direction Y are being connected preferably by soldering. However, if the respective mounting holes 16A are located at the positions corresponding to the center (center line Z) of the terminal group 37A of the respective board connecting portions 35A in the column direction Y as in this embodiment, the degree of inclination of the circuit board 90 can be reduced or suppressed even if the circuit board 90 should be inclined in such a direction that the board connecting portions 35A located at the other end in the column direction Y come out of the corresponding connection holes 91 while the board connecting portions 35A located at the one end in the column direction Y are being connected preferably by soldering. Therefore, the action of an excessive stress on the other end of the terminal group 37A in the column direction Y can be prevented.

In this way, the horizontal connector 10A is fixed in a proper (preferably substantially horizontal) posture to or on the circuit board 90.

On the other hand, in the case of selecting the vertical connector 10B, the substantially straight terminal fittings 30B are first mounted by being at least partly pressed or inserted into the fitting holes 14B from the mounting side (preferably substantially from above). Subsequently, upon mounting the vertical connector 10B on the circuit board 90, the board connecting portions 35B of the respective terminal fittings 30B are at least partly inserted into the corresponding connection holes 91 of the circuit board 90 and the mounting holes 16B of the respective mounting portions 12B are substantially aligned to communicate with the corresponding fixing holes 92 of the circuit board 90. Thereafter, when the respective mounting portions 12B are fixed by mounting members (preferably by tapping screws 80) at least partly inserted into the mounting holes 16B and the respective board connecting portions 35B are connected with the connection holes 91 (preferably by press-fitting and/or soldering) in the same manner as described above, the vertical connector 10B is fixed in a posture in which the opening surface OS-B of the receptacle 11 B is facing in the direction OD-B at an angle different from 0° or 180°, preferably substantially normal to the board surface direction BSD of the circuit board 90 or in a vertical posture to the circuit board 90. Since the respective mounting holes 16B preferably are formed at positions substantially corresponding to the center (center line Z) of the terminal group 37B in the column direction Y, the above effect of satisfactorily performing the (preferably solder) connecting operation at the opposite ends of the terminal group 37B in the column direction Y can be fulfilled.

As described above, this embodiment has the following effects.

Since the respective board connecting portions 35A, 35B and the respective mounting holes 16A, 16B preferably are arranged at the substantially same positions in the horizontal connector 10A and vertical connector 10B, the respective connection holes 91 and the respective fixing holes 92 of the circuit board 90 are also arranged at the substantially same positions, wherefore one type of the circuit board 90 can be commonly used for both connectors 10A, 10B. Hence, the versatility of the circuit board 90 can be improved and a cost increase can be suppressed.

Further, since the respective mounting holes 16A, 16B preferably are arranged in at least one pair at the substantially opposite sides of the terminal groups 37A, 37B in the row direction X in both horizontal connector 10A and vertical connector 10B, the formation range of the connection holes 91 and the fixing holes 92 of the circuit board 90 can be made smaller in the column direction Y, wherefore a space in the column direction Y can be effectively utilized.

Furthermore, the mounting portions 12A of the horizontal connector 10A project substantially backward (or in a direction substantially opposite to the opening direction OD-A) from or from close to the rear end(s) of the (preferably substantially opposite) side surface(s) of the receptacle 11A and are arranged to at least partly cover the exposed parts of the respective terminal fittings 30A at the (preferably substantially opposite) side(s) in the row direction X. Such an arrangement can prevent the exposed parts of the respective terminal fittings 30A from being deformed by interference with external matters.

Accordingly, to make a circuit board more versatile, there are prepared or provided a horizontal connector 10A to be mounted on a circuit board 90 with a connecting direction OD-A with a mating connector orientated substantially parallel to the board surface direction BSD of a circuit board 90 and a vertical connector 10B to be mounted on the circuit board 90 with a connecting direction OD-B with a mating connector orientated at an angle different from 0° or 180°, preferably substantially normal to the board surface direction BSD of the circuit board 90. In the horizontal connector 10A and vertical connector 10B, parts (board connecting portions 35A, 35B) of terminal fittings 30A, 30B to be at least partly inserted into connection holes 91 and parts (mounting holes 16A, 16B) of mounting portions 12A, 12B to be mounted with respect to fixing holes 92 are arranged at the substantially same positions. Therefore, the circuit board 90 can be commonly used for both horizontal connector 10A and vertical connector 10B.

### <Other Embodiments>

The present invention is not limited to the above described and illustrated embodiment. For example, the following embodiments are also embraced by the technical scope of the present invention as defined by the claims. It should be appreciated that the following embodiments are applicable to both horizontal connectors and vertical connectors.
(1) The mounting portions may be arranged at the substantially opposite sides of the terminal group in the row direction while being displaced toward one side of the terminal group in the column direction.
(2) The mounting portions may be arranged at the substantially opposite sides or one side of the terminal group in the row direction.
(3) The mounting portions may be formed as resiliently deformable leg pieces and may be attached to the circuit board by being resiliently engaged with the opening edges of the fixing holes at the underside of the circuit board.
(4) Screws as mounting members may be inserted through the mounting holes and fastened with nuts. Any other mounting member such as rivets, clamps or the like may be used as the mounting member to fasten the connector to the circuit board.
(5) The mounting holes may penetrate through the mounting portions.
(6) The terminal fittings may be formed as press-fit terminals to be pressed into contact with contact points formed on the inner surfaces of the connection holes of the circuit board.
(7) The terminal fittings may be inserted into the fitting holes from front.
(8) The terminal fittings may be mounted through the back wall of the receptacle by insert molding.
(9) The terminal fittings may be mounted at one stage (one row in the column direction), three stage (three rows in the column direction) or more through the back wall of the receptacle.
(10) The present invention is also applicable to hybrid type circuit board connectors in which terminal fittings having different shapes and/or sizes (such as large-size terminal fittings and small-size terminal fittings) are contemporarily or mixedly mounted.
(11) It should be understood that the connectors may have any orientation with respect to the circuit board. Furthermore, three or more different connectors having different orientations but all having parts (such as board connecting portions) of terminal fittings to be at least partly inserted into connection holes and parts (such as mounting holes) of mounting portions to be mounted with respect to fixing holes being arranged at the substantially same positions.

### LIST OF REFERENCE NUMERALS

- 10A: horizontal connector
- 10B: vertical connector
- 11 A, 11B: receptacle
- 12A, 12B: mounting portion
- 13A, 13B: back wall
- 16A, 16B: mounting hole
- 30A, 30B: terminal fitting
- 35A, 35B: board connecting portion
- 37A, 37B: terminal group
- 90: circuit board
- 91: connection hole
- 92: fixing hole

## Claims

1. A set of circuit board connectors comprising at least two types of connectors (10A, 10B), each connector (10A, 10B) comprising a receptacle (11A, 11B), into which a mating connector is at least partly fittable, terminal fittings (30A, 30B) mounted through a back wall (13A, 13B) of the receptacle (11A, 11 B) and projecting outwardly from the back wall (13A, 13B) to be at least partly inserted into connection holes (91) of a circuit board (90), and mounting portions (12A, 12B) to be mounted in conformity with fixing holes (92) of the circuit board (90), wherein:
the at least two types of connectors (10A, 10B) include:
a first connector (10A) to be mounted on the circuit board (90) with a connecting direction (OD-A) with the mating connector oriented substantially parallel to the board surface direction (BSD) of the circuit board (90), and
a second connector (10B) to be mounted on the circuit board (90) with a connecting direction (OD-B) with the mating connector oriented at an angle different from 0° or 180°, preferably substantially normal to the board surface direction (BSD) of the circuit board (90), and
parts (35A, 35B) of the respective terminal fittings (30A, 30B) to be at least partly inserted into the connection holes (91) and parts (16A, 16B) of the mounting portions (12A, 12B) to be mounted with respect to the fixing holes (92) are arranged at the substantially same positions in the first connector (10A) and second connector (10B), wherein
in both the first connector (10A) and the second connector (10B) the parts (35A, 35B) of the respective terminal fittings (30A, 30B) and the parts (16A, 16B) of the mounting portions (12A, 12B) are identical in shape and/or arranged in the same intervals, so that the shapes and arrangements thereof coincide, such that if the parts (35A, 35B) of the respective terminal fittings (30A, 30B) of the first connector (10A) and the second connector (10B) and the parts (16A, 16B) of the mounting portions (12A, 12B) of the first connector (10A) and the second connector (10B) are projected on the board surface of the circuit board (90), projected images substantially match and overlap at the same positions,
the mounting portions (12A, 12B) are formed to project outwardly from the receptacle (11A, 11B),
a multitude of the parts (35A, 35B) of the respective terminal fittings (30A, 30B) to be at least partly inserted into the connection holes (91) are arranged in a row direction (X) and a column direction (Y) to form a terminal group (37A, 37B), and
the parts (16A, 16B) of the mounting portions (12A, 12B) to be mounted with respect to the fixing holes (92) are arranged at positions corresponding to the center (Z) of the terminal group (37A, 37B) in the column direction (Y),
**characterized in that**
the mounting portions (12A) of the first connector (10A) are arranged at the substantially opposite sides in the row direction (X) with the outwardly projecting parts of the respective terminal fittings (30A) from the back wall (13A) of the receptacle (11A) located therebetween and are formed to at least partly cover the respective terminal fittings (30A) at the substantially opposite sides in the row direction (X).

2. A set of circuit board connectors according to claim 1, wherein the parts (16A, 16B) of the mounting portions (12A, 12B) to be mounted with respect to the fixing holes (92) are arranged at least in a pair at the substantially opposite sides of the terminal group (37A, 37B) in the row direction (X).

3. A set of circuit board connectors according to one or more of the preceding claims, wherein the mounting portion (12A) has a projecting distance which is set beyond the height of the terminal fitting(s) (30A) to be located most closely to the circuit board (90).

4. A set of circuit board connectors according to one or more of the preceding claims, wherein the second connector (10B) comprises at least one pair of lateral projecting pieces (18) projecting toward the connector board (90) so that exposed parts of the terminal fittings (30B) except the leading end portions are arranged to be at least partly protected by the projecting pieces (18), preferably between the two projecting pieces (18).

5. A set of circuit board connectors according to one or more of the preceding claims, wherein mounting members are at least partly insertable into the fixing holes (92) preferably from a side opposite to the mounting side of the circuit board (90) and the leading ends thereof are engaged with mounting holes (16A, 16B) of the respective mounting portions (12A, 12B).

6. A set of circuit board connectors according to claim 5, wherein the mounting members comprise one or more tapping screws (80), wherein the external threads of the tapping screws (80) can bite in or engage the inner surfaces of the respective mounting holes (16A, 16B), whereby the receptacle (11A, 11B) can be fixed by the tapping screws (80).

7. A method of mounting a connector (10A; 10B) to a circuit board (90) comprising the following steps:
selecting one connector out of a set of circuit board connectors comprising at least two types of connectors (10A, 10B), each connector (10A, 10B) comprising a receptacle (11A, 11B), into which a mating connector is at least partly fittable, terminal fittings (30A, 30B) mounted through a back wall (13A, 13B) of the receptacle (11A, 11B) and projecting outwardly from the back wall (13A, 13B) to be at least partly inserted into connection holes (91) of a circuit board (90), and mounting portions (12A, 12B) to be mounted in conformity with fixing holes (92) of the circuit board (90), wherein:
the at least two types of connectors (10A, 10B) include:
a first connector (10A) to be mounted on the circuit board (90) with a connecting direction (OD-A) with the mating connector oriented substantially parallel to the board surface direction (BSD) of the circuit board (90), and
a second connector (10B) to be mounted on the circuit board (90) with a connecting direction (OD-B) with the mating connector oriented at an angle different from 0° or 180°, preferably substantially normal to the board surface direction (BSD) of the circuit board (90), and
parts (35A, 35B) of the respective terminal fittings (30A, 30B) to be at least partly inserted into the connection holes (91) and parts (16A, 16B) of the mounting portions (12A, 12B) to be mounted with respect to the fixing holes (92) are arranged at the substantially same positions in the first connector (10A) and second connector (10B),
**characterized by**
mounting the selected connector to the connector board (90) by at least partly inserting the parts (35A, 35B) of the respective terminal fittings (30A, 30B) into the connection holes (91) and mounting the parts (16A, 16B) of the mounting portions (12A, 12B) to the fixing holes (92), wherein
in both the first connector (10A) and the second connector (10B) the parts (35A, 35B) of the respective terminal fittings (30A, 30B) and the parts (16A, 16B) of the mounting portions (12A, 12B) are identical in shape and/or arranged in the same intervals, so that the shapes and arrangements thereof coincide, such that if the parts (35A, 35B) of the respective terminal fittings (30A, 30B) of the first connector (10A) and the second connector (10B) and the parts (16A, 16B) of the mounting portions (12A, 12B) of the first connector (10A) and the second connector (10B) are projected on the board surface of the circuit board (90), projected images substantially match and overlap at the same positions,
the mounting portions (12A, 12B) are formed to project outwardly from the receptacle (11A, 11B),
a multitude of the parts (35A, 35B) of the respective terminal fittings (30A, 30B) to be at least partly inserted into the connection holes (91) are arranged in a row direction (X) and a column direction (Y) to form a terminal group (37A, 37B),
the parts (16A, 16B) of the mounting portions (12A, 12B) to be mounted with respect to the fixing holes (92) are arranged at positions corresponding to the center (Z) of the terminal group (37A, 37B) in the column direction (Y), and
the mounting portions (12A) of the first connector (10A) are arranged at the substantially opposite sides in the row direction (X) with the outwardly projecting parts of the respective terminal fittings (30A) from the back wall (13A) of the receptacle (11A) located therebetween and are formed to at least partly cover the respective terminal fittings (30A) at the substantially opposite sides in the row direction (X).

## Patentansprüche

1. Leiterplattensteckersatz, umfassend wenigstens zwei Typen von Steckern (10A, 10B), wobei jeder Stecker bzw. Verbinder (10A, 10B) eine Aufnahme (11A, 11B), in welche ein zusammenpassender Stecker wenigstens teilweise einpassbar ist, Anschlusspassstücke (30A, 30B), welche durch eine Rückwand (13A, 13B) der Aufnahme (11A, 11B) montiert sind und nach außen von der Rückwand (13A, 13B) vorragen, um wenigstens teilweise in Verbindungslöcher (91) einer Leiterplatte (90) eingesetzt zu werden, und Montageabschnitte (12A, 12B) umfasst, um in Übereinstimmung mit Festlegungslöchern (92) der Leiterplatte (90) montiert zu sein, wobei:
die wenigstens zwei Typen von Steckern (10A, 10B) beinhalten:
einen ersten Stecker (10A), welcher an der Leiterplatte (90) zu montieren ist, wobei eine Verbindungsrichtung (OD-A) mit dem zusammenpassenden Stecker im Wesentlichen parallel zu der Plattenoberflächenrichtung (BSD) der Leiterplatte (90) orientiert ist, und
einen zweiten Stecker (10B), welcher auf der Leiterplatte (90) zu montieren ist, wobei eine Verbindungsrichtung (ODB) mit dem zusammenpassenden Stecker unter einem von 0° oder 180° verschiedenen Winkel, vorzugsweise im Wesentlichen normal auf die Plattenoberflächenrichtung (BSD) der Leiterplatte (90) orientiert ist, und
Teile (35A, 35B) der jeweiligen Anschlusspassstücke (30A, 30B), um wenigstens teilweise in die Verbindungslöcher (91) eingesetzt zu sein, und Teile (16A, 16B) der Montageabschnitte (12A, 12B), um relativ zu den Festlegungslöchern (92) montiert zu sein, an den im Wesentlichen selben Positionen in dem ersten Stecker (10A) und dem zweiten Stecker (10B) angeordnet sind, wobei
sowohl in dem ersten Stecker (10A) als auch in dem zweiten Stecker (10B) die Teile (35A, 35B) der jeweiligen Anschlusspassstücke (30A, 30B) und die Teile (16A, 16B) der Montageabschnitte (12A, 12B) ident in einer Form bzw. Gestalt und/oder in denselben Abständen angeordnet sind, so dass die Formen und Anordnungen davon zusammenfallen, so dass, wenn die Teile (35A, 35B) der jeweiligen Anschlusspassstücke (30A, 30B) des ersten Steckers (10A) und des zweiten Steckers (10B) und die Teile (16A, 16B) der Montageabschnitte (12A, 12B) des ersten Steckers (10A) und des zweiten Steckers (10B) auf die Plattenoberfläche der Leiterplatte (90) vorragen bzw. projiziert sind, projizierte Bilder im Wesentlichen übereinstimmen und an denselben Positionen überlappen,
die Montageabschnitte (12A, 12B) ausgebildet sind, um nach außen von der Aufnahme (11A, 11B) vorzuragen,
eine Mehrzahl der Teile (35A, 35B) der jeweiligen Anschlusspassstücke (30A, 30B), um wenigstens teilweise in die Verbindungslöcher (91) eingesetzt zu sein, in einer Reihenrichtung (X) und einer Spaltenrichtung (Y) angeordnet ist, um eine Anschlussgruppe (37A, 37B) zu bilden, und
die Teile (16A, 16B) der Montageabschnitte (12A, 12B), um relativ zu den Festlegungslöchern (92) montiert zu sein, an Positionen entsprechend dem Zentrum (Z) der Anschlussgruppe (37A, 37B) in der Spaltenrichtung (Y) angeordnet sind,
**dadurch gekennzeichnet, dass**
die Montageabschnitte (12A) des ersten Steckers (10A) an den im Wesentlichen gegenüberliegenden Seiten in der Reihenrichtung (X) angeordnet sind, wobei die nach außen vorragenden Teile der jeweiligen Anschlusspassstücke (30A) von der Rückwand (13A) der Aufnahme (11A) dazwischen angeordnet sind, und ausgebildet sind, um wenigstens teilweise die jeweiligen Anschlusspassstücke (30A) an den im Wesentlichen gegenüberliegenden Seiten in der Reihenrichtung (X) abzudecken.

2. Leiterplattensteckersatz nach Anspruch 1, wobei die Teile (16A, 16B) der Montageabschnitte (12A, 12B), um relativ zu den Festlegungslöchern (92) montiert zu sein, wenigstens in einem Paar an den im Wesentlichen gegenüberliegenden Seiten der Anschlussgruppe (37A, 37B) in der Reihenrichtung (X) angeordnet sind.

3. Leiterplattensteckersatz nach einem oder mehreren der vorangehenden Ansprüche, wobei der Montageabschnitt (12A) einen vorragenden Abstand aufweist, welcher hinausgehend über die Höhe des (der) Anschlusspassstücks (-stücke) (30A) eingestellt ist, um am nächsten zu der Leiterplatte (90) angeordnet zu sein.

4. Leiterplattensteckersatz nach einem oder mehreren der vorangehenden Ansprüche, wobei der zweite Stecker (10B) wenigstens ein Paar von lateralen vorragenden Stücken (18) umfasst, welche in Richtung zu der Leiterplatte (90) vorragen, so dass freigelegte Teile der Anschlusspassstücke (30B) mit Ausnahme der vorderen Endabschnitte angeordnet sind, um wenigstens teilweise durch die vorragenden Stücke (18), vorzugsweise zwischen den zwei vorragenden Stücken (18) geschützt zu sein.

5. Leiterplattensteckersatz nach einem oder mehreren der vorangehenden Ansprüche, wobei Montageglieder wenigstens teilweise in die Festlegungslöcher (92) vorzugsweise von einer Seite gegenüberliegend zu der Montageseite der Leiterplatte (90) einsetzbar sind und die vorderen Enden davon in Eingriff mit Montagelöchern (16A, 16B) der jeweiligen Montageabschnitte (12A, 12B) stehen bzw. gelangen.

6. Leiterplattensteckersatz nach Anspruch 5, wobei die Montageglieder eine oder mehrere Gewinde- bzw. Schneidschraube(n) (80) umfassen, wobei die Außengewinde der Gewindeschrauben (80) in die inneren Oberflächen der jeweiligen Montagelöcher (16A, 16B) beißen oder mit diesen in Eingriff gelangen können, wodurch die Aufnahme (11A, 11B) durch die Gewindeschrauben (80) fixiert werden kann.

7. Verfahren zum Montieren eines Steckers (10A; 10B) auf einer Leiterplatte (90), umfassend die folgenden Schritte:
Auswählen eines Verbinders bzw. Steckers aus einem Leiterplattensteckersatz, umfassend wenigstens zwei Typen von Steckern (10A, 10B), wobei jeder Stecker (10A, 10B) eine Aufnahme (11A, 11B), in welche ein zusammenpassender Stecker wenigstens teilweise einpassbar ist, Anschlusspassstücke (30A, 30B), welche durch eine Rückwand (13A, 13B) der Aufnahme (11A, 11B) montiert werden und nach außen von der Rückwand (13A, 13B) vorragen, um wenigstens teilweise in Verbindungslöcher (91) einer Leiterplatte (90) eingesetzt zu werden, und Montageabschnitte (12A, 12B) umfasst, um in Übereinstimmung mit Festlegungslöchern (92) der Leiterplatte (90) montiert zu werden, wobei:
die wenigstens zwei Typen von Steckern (10A, 10B) beinhalten:
einen ersten Stecker (10A), welcher an der Leiterplatte (90) zu montieren ist, wobei eine Verbindungsrichtung (OD-A) mit dem zusammenpassenden Stecker im Wesentlichen parallel zu der Plattenoberflächenrichtung (BSD) der Leiterplatte (90) orientiert wird, und
einen zweiten Stecker (10B), welcher auf der Leiterplatte (90) zu montieren ist, wobei eine Verbindungsrichtung (ODB) mit dem zusammenpassenden Stecker unter einem von 0° oder 180° verschiedenen Winkel, vorzugsweise im Wesentlichen normal auf die Plattenoberflächenrichtung (BSD) der Leiterplatte (90) orientiert wird, und
Teile (35A, 35B) der jeweiligen Anschlusspassstücke (30A, 30B), um wenigstens teilweise in die Verbindungslöcher (91) eingesetzt zu werden, und Teile (16A, 16B) der Montageabschnitte (12A, 12B), um relativ zu den Festlegungslöchern (92) montiert zu werden, an den im Wesentlichen selben Positionen in dem ersten Stecker (10A) und dem zweiten Stecker (10B) angeordnet werden,
**gekennzeichnet durch**
ein Montieren des ausgewählten Steckers an der Leiterplatte (90) **durch** ein wenigstens teilweises Einsetzen der Teile (35A, 35B) der jeweiligen Anschlusspassstücke (30A, 30B) in die Verbindungslöcher (91) und ein Montieren der Teile (16A, 16B) der Montageabschnitte (12A, 12B) an den Festlegungslöchern (92), wobei
sowohl in dem ersten Verbinder (10A) als auch in dem zweiten Verbinder (10B) die Teile (35A, 35B) der jeweiligen Anschlusspassstücke (30A, 30B) und die Teile (16A, 16B) der Montageabschnitte (12A, 12B) ident in einer Form bzw. Gestalt sind und/oder in denselben Abständen angeordnet werden, so dass die Formen und Anordnungen davon zusammenfallen, so dass, wenn die Teile (35A, 35B) der jeweiligen Anschlusspassstücke (30A, 30B) des ersten Steckers (10A) und des zweiten Steckers (10B) und die Teile (16A, 16B) der Montageabschnitte (12A, 12B) des ersten Steckers (10A) und des zweiten Steckers (10B) auf die Plattenoberfläche der Leiterplatte (90) vorragen bzw. projiziert werden, projizierte Bilder im Wesentlichen übereinstimmen und an denselben Positionen überlappen,
die Montageabschnitte (12A, 12B) ausgebildet werden, um nach außen von der Aufnahme (11A, 11B) vorzuragen,
eine Mehrzahl der Teile (35A, 35B) der jeweiligen Anschlusspassstücke (30A, 30B), um wenigstens teilweise in die Verbindungslöcher (91) eingesetzt zu werden, in einer Reihenrichtung (X) und einer Spaltenrichtung (Y) angeordnet wird, um eine Anschlussgruppe (37A, 37B) zu bilden,
die Teile (16A, 16B) der Montageabschnitte (12A, 12B), um relativ zu den Festlegungslöchern (92) montiert zu werden, an Positionen entsprechend dem Zentrum (Z) der Anschlussgruppe (37A, 37B) in der Spaltenrichtung (Y) angeordnet werden, und
die Montageabschnitte (12A) des ersten Steckers (10A) an den im Wesentlichen gegenüberliegenden Seiten in der Reihenrichtung (X) angeordnet werden, wobei die nach außen vorragenden Teile der jeweiligen Anschlusspassstücke (30A) von der Rückwand (13A) der Aufnahme (11A) dazwischen angeordnet werden, und ausgebildet werden, um wenigstens teilweise die jeweiligen Anschlusspassstücke (30A) an den im Wesentlichen gegenüberliegenden Seiten in der Reihenrichtung (X) abzudecken.

## Revendications

1. Ensemble de connecteurs de carte de circuit imprimé comprenant au moins deux types de connecteurs (10A, 10B), chaque connecteur (10A, 10B) comprenant un socle (11A, 11B) dans lequel un connecteur conjugué peut au moins partiellement être ajusté, des raccords de borne (30A, 30B) montés à travers une paroi arrière (13A, 13B) du socle (11A, 11B) et faisant saillie vers l'extérieur depuis la paroi arrière (13A, 13B) pour être au moins partiellement insérés dans des orifices de connexion (91) d'une carte de circuit imprimé (90) et des portions de montage (12A, 12B) devant être montées en conformité avec des orifices de fixation (92) de la carte de circuit imprimé (90), dans lequel :
les au moins deux types de connecteurs (10A, 10B) incluent :
un premier connecteur (10A) devant être monté sur la carte de circuit imprimé (90) avec une direction de connexion (OD-A) avec le connecteur conjugué orientée essentiellement parallèlement à la direction de surface de carte (BSD) de la carte de circuit imprimé (90), et
un second connecteur (10B) devant être monté sur la carte de circuit imprimé (90) avec une direction de connexion (OD-B) avec le connecteur conjugué orientée à un angle différent de 0° ou 180°, de préférence essentiellement perpendiculairement à la direction de surface de carte (BSD) de la carte de circuit imprimé (90), et
des parties (35A, 35B) des raccords de borne respectifs (30A, 30B) devant être au moins partiellement insérées dans les orifices de connexion (91) et des parties (16A, 16B) des portions de montage (12A, 12B) devant être montées par rapport aux orifices de fixation (92) sont agencées à essentiellement les mêmes positions dans les premier connecteur (10A) et second connecteur (10B), dans lequel dans à la fois le premier connecteur (10A) et le second connecteur (10B), les parties (35A, 35B) des raccords de borne respectifs (30A, 30B) et les parties (16A, 16B) des portions de montage (12A, 12B) sont de forme identique et/ou agencées dans les mêmes intervalles de sorte que les formes et agencements de celles-ci coïncident de sorte que, si les parties (35A, 35B) des raccords de borne respectifs (30A, 30B) du premier connecteur (10A) et du second connecteur (10B) et les parties (16A, 16B) des portions de montage (12A, 12B) du premier connecteur (10A) et du second connecteur (10B) sont projetées sur la surface de carte de la carte de circuit imprimé (90), des images projetées correspondent et se chevauchent essentiellement aux mêmes positions,
les portions de montage (12A, 12B) sont formées pour faire saillie vers l'extérieur depuis le socle (11A, 11B),
une multitude des parties (35A, 35B) des raccords de borne respectifs (30A, 30B) devant être au moins partiellement insérées dans les orifices de connexion (91) sont agencées dans une direction de rangée (X) et une direction de colonne (Y) pour former un groupe de bornes (37A, 37B), et
les parties (16A, 16B) des portions de montage (12A, 12B) devant être montées par rapport aux orifices de fixation (92) sont agencées à des positions correspondant au centre (Z) du groupe de bornes (37A, 37B) dans la direction de colonne (Y),
**caractérisé en ce que**
les portions de montage (12A) du premier connecteur (10A) sont agencées sur les côtés essentiellement opposés dans la direction de rangée (X) avec les parties faisant saillie vers l'extérieur des raccords de borne respectifs (30A) depuis la paroi arrière (13A) du socle (11A) situées entre elles et sont formées pour recouvrir au moins partiellement les raccords de borne respectifs (30A) sur les côtés essentiellement opposés dans la direction de rangée (X).

2. Ensemble de connecteurs de carte de circuit imprimé selon la revendication 1, dans lequel les parties (16A, 16B) des portions de montage (12A, 12B) devant être montées par rapport aux orifices de fixation (92) sont agencées au moins en une paire sur les côtés essentiellement opposés du groupe de bornes (37A, 37B) dans la direction de rangée (X).

3. Ensemble de connecteurs de carte de circuit imprimé selon une ou plusieurs des revendications précédentes, dans lequel la portion de montage (12A) a une distance de saillie qui est réglée au-delà de la hauteur du/des raccord(s) de borne (30A) devant être situé(s) au plus près de la carte de circuit imprimé (90).

4. Ensemble de connecteurs de carte de circuit imprimé selon une ou plusieurs des revendications précédentes, dans lequel le second connecteur (10B) comprend au moins une paire de pièces saillantes latérales (18) faisant saillie vers la carte de connecteur (90) de sorte que des parties exposées des raccords de borne (30B) mis à part les portions d'extrémité de tête sont agencées pour être au moins partiellement protégées par les pièces saillantes (18), de préférence entre les deux pièces saillantes (18).

5. Ensemble de connecteurs de carte de circuit imprimé selon une ou plusieurs des revendications précédentes, dans lequel des éléments de montage peuvent être au moins partiellement insérés dans les orifices de fixation (92) de préférence depuis un côté opposé au côté de montage de la carte de circuit imprimé (90) et les extrémités de tête de ceux-ci sont engagées avec des orifices de montage (16A, 16B) des portions de montage respectives (12A, 12B).

6. Ensemble de connecteurs de carte de circuit imprimé selon la revendication 5, dans lequel les éléments de montage comprennent une ou plusieurs vis à tôle (80), dans lequel les filetages externes des vis à tôle (80) peuvent mordre dans ou s'engager avec les surfaces internes des orifices de montage respectifs (16A, 16B), moyennant quoi le socle (11A, 11B) peut être fixé par les vis à tôle (80).

7. Procédé de montage d'un connecteur (10A ; 10B) sur une carte de circuit imprimé (90) comprenant les étapes suivantes :
sélectionner un connecteur parmi un ensemble de connecteurs de carte de circuit imprimé comprenant au moins deux types de connecteurs (10A, 10B), chaque connecteur (10A, 10B) comprenant un socle (11A, 11B) dans lequel un connecteur conjugué peut au moins partiellement être ajusté, des raccords de borne (30A, 30B) montés à travers une paroi arrière (13A, 13B) du socle (11A, 11B) et faisant saillie vers l'extérieur depuis la paroi arrière (13A, 13B) pour être au moins partiellement insérés dans des orifices de connexion (91) d'une carte de circuit imprimé (90) et des portions de montage (12A, 12B) devant être montées en conformité avec des orifices de fixation (92) de la carte de circuit imprimé (90), dans lequel :
les au moins deux types de connecteurs (10A, 10B) incluent :
un premier connecteur (10A) devant être monté sur la carte de circuit imprimé (90) avec une direction de connexion (OD-A) avec le connecteur conjugué orientée essentiellement parallèlement à la direction de surface de carte (BSD) de la carte de circuit imprimé (90), et
un second connecteur (10B) devant être monté sur la carte de circuit imprimé (90) avec une direction de connexion (OD-B) avec le connecteur conjugué orientée à un angle différent de 0° ou 180°, de préférence essentiellement perpendiculairement à la direction de surface de carte (BSD) de la carte de circuit imprimé (90), et
des parties (35A, 35B) des raccords de borne respectifs (30A, 30B) devant être au moins partiellement insérées dans les orifices de connexion (91) et des parties (16A, 16B) des portions de montage (12A, 12B) devant être montées par rapport aux orifices de fixation (92) sont agencées à essentiellement les mêmes positions dans les premier connecteur (10A) et second connecteur (10B),
**caractérisé par** le fait de
monter le connecteur sélectionné sur la carte de connecteur (90) en insérant au moins partiellement les parties (35A, 35B) des raccords de borne respectifs (30A, 30B) dans les orifices de connexion (91) et montant les parties (16A, 16B) des portions de montage (12A, 12B) sur les orifices de fixation (92) ; dans lequel dans à la fois le premier connecteur (10A) et le second connecteur (10B), les parties (35A, 35B) des raccords de borne respectifs (30A, 30B) et les parties (16A, 16B) des portions de montage (12A, 12B) sont de forme identique et/ou agencées dans les mêmes intervalles de sorte que les formes et agencements de celles-ci coïncident de sorte que, si les parties (35A, 35B) des raccords de borne respectifs (30A, 30B) du premier connecteur (10A) et du second connecteur (10B) et les parties (16A, 16B) des portions de montage (12A, 12B) du premier connecteur (10A) et du second connecteur (10B) sont projetées sur la surface de carte de la carte de circuit imprimé (90), des images projetées correspondent et se chevauchent essentiellement aux mêmes positions,
les portions de montage (12A, 12B) sont formées pour faire saillie vers l'extérieur depuis le socle (11A, 11B),
une multitude des parties (35A, 35B) des raccords de borne respectifs (30A, 30B) devant être au moins partiellement insérées dans les orifices de connexion (91) sont agencées dans une direction de rangée (X) et une direction de colonne (Y) pour former un groupe de bornes (37A, 37B),
les parties (16A, 16B) des portions de montage (12A, 12B) devant être montées par rapport aux orifices de fixation (92) sont agencées à des positions correspondant au centre (Z) du groupe de bornes (37A, 37B) dans la direction de colonne (Y), et
les portions de montage (12A) du premier connecteur (10A) sont agencées sur les côtés essentiellement opposés dans la direction de rangée (X) avec les parties faisant saillie vers l'extérieur des raccords de borne respectifs (30A) depuis la paroi arrière (13A) du socle (11A) situées entre elles et sont formées pour recouvrir au moins partiellement les raccords de borne respectifs (30A) sur les côtés essentiellement opposés dans la direction de rangée (X).
